# FASCICULE DE BREVET EUROPEEN

(11) **EP 3 748 371 B1**
(45) Date de publication et mention de la délivrance du brevet: **08.01.2025**
(21) Numéro de dépôt: 20178462.6
(22) Date de dépôt: 05.06.2020
(51) Int. Cl.: G01R 15/18

(54) **CAPTEUR DE COURANT ET SYSTÈME DE MESURE COMPORTANT UN TEL CAPTEUR DE COURANT**
STROMSENSOR UND MESSSYSTEM, DAS EINEN SOLCHEN STROMSENSOR UMFASST
CURRENT SENSOR AND MEASURING SYSTEM COMPRISING SUCH A CURRENT SENSOR

(30) Priorité: 07.06.2019 FR 1906095
(43) Date de publication de la demande: 09.12.2020
(73) Titulaire: Schneider Electric Industries SAS, 92500 Rueil Malmaison (FR)
(72) Inventeur: RONDOT, Loïc, 38050 GRENOBLE CEDEX 09 (FR); URANKAR, Lionel, 38050 GRENOBLE CEDEX 09 (FR)
(74) Mandataire: Lavoix

(56) Documents cités:
- US-A1- 2003 011 458
- US-A1- 2009 058 398
- US-A1- 2014 198 463
- US-A1- 2019 154 733

## Description

La présente invention concerne un capteur de courant et un système de mesure comportant un tel capteur de courant.

Les enroulements de Rogowski sont des capteurs de courant capables de mesurer l'intensité d'un courant alternatif circulant dans un conducteur électrique.

Un tel capteur comporte généralement une bobine enroulée qui délimite un contour fermé autour d'une ouverture centrale dans laquelle est reçue le conducteur électrique. Le courant circulant dans le conducteur électrique induit une tension électrique aux bornes de la bobine.

Les enroulements de Rogowski peuvent être fabriqués sur un support de circuit imprimé (PCB). Par exemple, un substrat isolant est percé d'une pluralité de trous traversants métallisés agencés sur les faces du substrat avec un motif prédéfini et disposés pour délimiter un contour fermé autour d'une ouverture centrale. La succession des trous métallisés et de pistes électriquement conductrices formées sur des couches du substrat définissent ensemble un chemin électriquement conducteur qui forme un enroulement de la bobine.

Des exemples de capteurs de courant connus sont décrits par les documents US 2003/011458 A1 et US 2014/198463 A1.

Les enroulements de Rogowski sur circuit imprimé (*PCB Rogowski coils* en anglais) ont notamment pour avantages d'être relativement simples et peu coûteux à fabriquer à l'échelle industrielle. Ils sont aussi faciles à miniaturiser.

Un inconvénient de ces capteurs est qu'ils présentent un gain faible (par exemple de l'ordre de 10 µV par Ampère), ce qui rend difficile la détection de petites variations de courant dans le conducteur électrique. Cette limitation est rédhibitoire dans certaines applications, par exemple lorsqu'un tel capteur est utilisé comme capteur de courant dans un appareil de protection électrique dans une installation de distribution d'électricité.

Il existe donc un besoin pour des capteurs de courant, notamment des enroulements de Rogowski sur circuit imprimé, qui remédient à ces inconvénients.

Un premier aspect de l'invention concerne un capteur de courant, conformément à la revendication 1.

Selon des aspects avantageux mais non obligatoires, un tel capteur de courant peut incorporer une ou plusieurs des caractéristiques suivantes, prises isolément ou suivant toute combinaison techniquement admissible :
- La bobine comporte une pluralité de portions de bobine connectées électriquement en série, les portions de bobine étant de forme rectiligne et agencées de manière à former un contour fermé en forme de quadrilatère autour de l'ouverture centrale.
- La couche ferromagnétique est commune à toutes les portions de bobines.
- La couche ferromagnétique est divisée en plusieurs parties chacune associée à une des portions de bobine.
- La couche ferromagnétique comporte une sous-couche d'un alliage de fer et de nickel et deux sous-couches de cuivre empilées de part et d'autre de la sous-couche d'alliage de fer et de nickel.
- L'alliage de fer et de nickel est un alliage Fe-Ni36%.
- L'épaisseur de la couche ferromagnétique est supérieure ou égale à 150 µm.
- Le substrat comporte un via traversant perpendiculaire au plan du substrat, et dans lequel la couche ferromagnétique est séparée dudit via traversant par une zone tampon dépourvue de matériau ferromagnétique.
- Le substrat et un support de circuit imprimé comportant une ou plusieurs couches empilées d'un matériau polymère durci.

Selon un autre aspect de l'invention, un système de mesure comporte un capteur de courant tel que décrit précédemment et un circuit électronique de traitement configuré pour traiter le signal mesuré par le capteur de courant.

L'invention sera mieux comprise et d'autres avantages de celle-ci apparaîtront plus clairement à la lumière de la description qui va suivre d'un mode de réalisation d'un capteur de courant donnée uniquement à titre d'exemple et faite en référence aux dessins annexés, dans lesquels :
[Fig 1] la figure 1 est une représentation schématique d'un système de mesure comportant un capteur de courant conforme à des modes de réalisation de l'invention ;
[Fig 2] la figure 2 est une représentation schématique d'un capteur de courant d'un premier mode de réalisation de l'invention ;
[Fig 3] la figure 3 est une représentation schématique selon une vue en coupe transversale du capteur de courant de la figure 2 ;
[Fig 4] la figure 4 est une représentation schématique d'un capteur de courant d'un deuxième mode de réalisation de l'invention ;

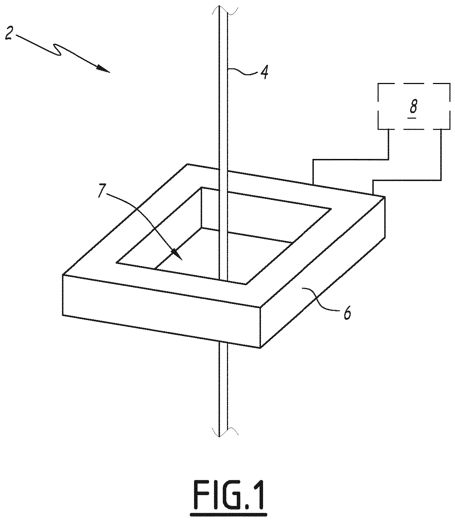

Sur la figure 1 est représenté un système de mesure 2 pour mesurer l'intensité d'un courant électrique circulant dans un conducteur électrique 4, tel qu'un câble ou un fil ou une barre de raccordement.

Le système 2 comporte ici un capteur de courant 6 et un circuit électronique de traitement 8 connecté au capteur de courant 6 et configuré pour traiter le signal mesuré par le capteur de courant 6.

Selon des modes de réalisation, le capteur de courant 6 est un enroulement de Rogowski comportant une bobine qui délimite un contour fermé autour d'une ouverture centrale 7 dans laquelle est reçue le conducteur 4. Des bornes d'extrémité de l'enroulement sont raccordées à une entrée du circuit de traitement 8.

Par exemple, le contour fermé présente une forme de polygone, notamment un quadrilatère, tel qu'un carré. En variante, d'autres formes peuvent être envisagées, tel qu'un cercle ou une ellipse.

Selon des exemples, le courant circulant dans le conducteur électrique induit une tension électrique aux bornes de la bobine. Cette tension est proportionnelle à la dérivée temporelle de l'intensité du courant qui circule dans le conducteur 4.

Le circuit de traitement 8 est, par exemple, configuré pour calculer la valeur du courant à partir du signal en tension fourni en sortie du capteur de courant 6.

Selon des modes de réalisation, le capteur de courant 6 et le circuit de traitement 8 peuvent être montés sur un même support de circuit imprimé.

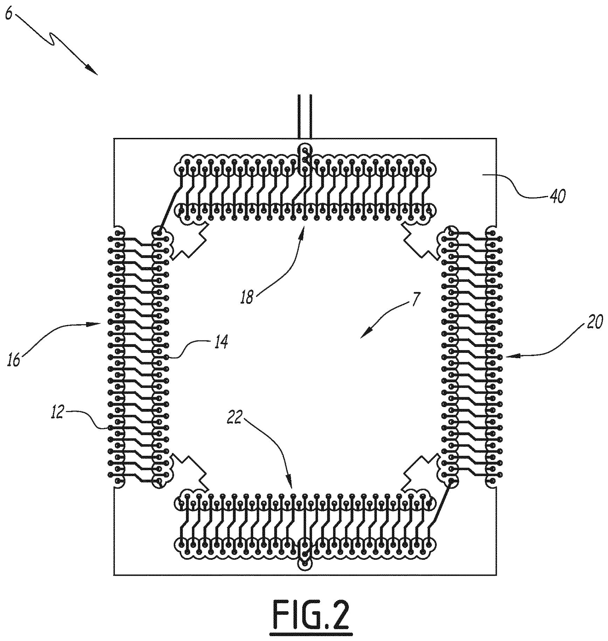

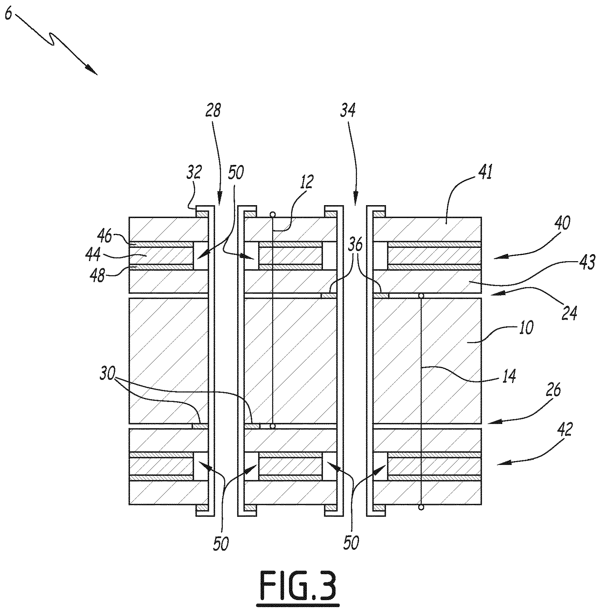

Un premier mode de réalisation du capteur de courant 6 est représenté sur les figures 2 et 3.

Le capteur de courant 6 comporte un substrat 10, ayant préférentiellement une forme plane.

Sur la figure 2, le capteur de courant 6 est représenté selon une vue en élévation dans un plan géométrique parallèle au substrat 10, montrant ainsi l'aspect du capteur 6 sur la face supérieure du substrat 10. Cependant, le substrat 10 n'est lui-même pas illustré afin de faciliter la lecture de la figure. Sur la figure 3, une partie du capteur de courant 6 est représentée dans un plan de coupe perpendiculaire au plan du substrat 10.

De préférence, le substrat 10 est électriquement isolant.

Selon des exemples, le substrat 10 est un support de circuit imprimé comportant une couche ou plusieurs couches empilées d'un matériau polymère durci, tel qu'une résine époxy de type « FR-4 ».

Le substrat 10 peut, par exemple, être fabriqué par laminage de plusieurs couches de tissus fibreux pré-imprégnés de résine, ou par dépôt de matière, ou par fabrication additive, ou par tout autre procédé approprié.

Selon des modes de réalisation, l'enroulement de Rogowski comporte au moins une bobine 12 enroulée autour d'une portion du substrat 10.

Par exemple, un conducteur électrique est enroulé en spires autour d'une couche ou de plusieurs des couches du substrat 10.

Selon des exemples, la bobine 12 traverse au moins en partie le substrat 10, par exemple au moyen de trous métallisés (aussi nommés « vias ») percés dans le substrat 10 en traversant le substrat 10 au moins sur une partie de son épaisseur et selon une direction perpendiculaire au plan du substrat 10. La bobine 12 comporte également des pistes électriquement conductrices, par exemples formées en métal, tel que du cuivre, qui s'étendent sur une ou plusieurs des couches du substrat 10, par exemple selon une direction parallèle au plan du substrat 10.

En d'autres termes, la bobine 12 est formée par l'association des trous métallisés qui s'étendent perpendiculairement au plan du substrat 10 et des pistes électriquement conductrices qui s'étendent sur des couches du substrat 10.

De façon générale, la dénomination de « bobine de Rogowski » ne préjuge pas d'une forme particulière d'une spire, celle-ci pouvant avoir une forme circulaire, ovoïde, polygonale ou quelconque. Dans le mode de réalisation décrit à titre d'exemple, les spires ont une forme polygonale, par exemple rectangulaire ou carrée.

De préférence, une partie de la bobine 12 émerge sur une face extérieure du substrat 10, comme cela sera décrit plus en détail dans ce qui suit.

Selon un ou plusieurs modes de réalisation, la bobine 12 comporte une pluralité de portions de bobine 16, 18, 20, 22 connectées électriquement en série.

Dans l'exemple illustré, les portions de bobine 16, 18, 20, 22, aussi nommées segments de bobine, sont de forme rectiligne et sont agencées de manière à former un contour fermé en forme de quadrilatère autour de l'ouverture centrale. Par exemple, le contour fermé est centré sur l'ouverture centrale.

Par exemple, quatre portions de bobine 16, 18, 20, 22 sont disposées bout à bout à angle droit autour de l'ouverture centrale, parallèlement au plan du substrat, en étant seulement reliées par une portion du fil formant l'enroulement.

Dans les modes de réalisation illustrés, l'enroulement de Rogowski comporte avantageusement l'association de deux bobines : une deuxième bobine 14 est connectée électriquement en série avec la une première bobine 12.

Il est néanmoins précisé que, selon des modes de réalisation alternatifs, l'enroulement de Rogowski peut ne comporter qu'une seule bobine. Ainsi, l'une ou l'autre des bobines 12 et 14 peut être omise.

Selon encore d'autres variantes, d'autres bobines additionnelles peuvent être associées de façon analogue pour former l'enroulement de Rogowski.

Dans l'exemple illustré, les bobines 12 et 14 sont enroulées autour de portions différentes du substrat 10 et sont entrelacées l'une avec l'autre.

Par exemple, par « entrelacées », on entend que, sur au moins une partie de la longueur du contour fermé, les spires respectives des bobines 12 et 14 sont disposées en alternance.

De préférence, lesdites portions du substrat 10 sont décalées selon une direction perpendiculaire au plan du substrat 10.

Dans l'exemple montré sur la figure 3, les spires de la première bobine 12 entourent une première portion du substrat 10 formée entre la face supérieure du substrat 10 et une interface 26 entre des sous-couches du substrat, grâce à des trous ou orifices, tels que des vias borgnes ou des vias traversants, s'étendant en profondeur dans le substrat 10 perpendiculairement au plan du substrat 10. La bobine 12 émerge sur une face supérieure du substrat 10.

Par exemple, l'interface 26 s'étend dans un plan géométrique parallèle au plan du substrat 10. Sur la figure 3, l'interface 26 est représentée avec un espacement exagéré pour faciliter la compréhension du dessin. Toutefois, en pratique, les sous-couches du substrat sont en contact direct au niveau de ces interfaces.

De façon analogue, les spires de la deuxième bobine 14 entourent une deuxième portion du substrat 10 formée entre la face inférieure du substrat 10 et une interface 24 entre des sous-couches similaires à l'interface 26, en passant par des trous s'étendant entre l'interface 24 et la face inférieure du substrat 10.

Dans cet exemple, l'interface 24 est située au-dessus de l'interface 26. La bobine 14 émerge sur une face inférieure du substrat 10.

Selon des modes de réalisation, la bobine additionnelle 14 comporte des parties de bobines similaires aux portions de bobines 16, 18, 20, 22 de la bobine 12.

De préférence, les portions de la bobine 14 sont alignées ou superposées avec les portions de bobines 16, 18, 20, 22 correspondantes de la bobine 12, selon une direction perpendiculaire au plan du substrat 10, comme illustré sur la figure 2.

Selon des modes de réalisation optionnels, des vias traversants 28 peuvent être formés dans le substrat 10, par exemple par perçage sur toute l'épaisseur du substrat 10 selon une direction perpendiculaire au plan du substrat 10.

De façon optionnelle, des plots métalliques 30, 36 sont déposés au contact des vias traversants au niveau des faces supérieure et inférieure des bobines lorsque ledit via traversant est au voisinage d'une bobine. Par exemple, les plots sont disposés au niveau des interfaces 24 ou 26.

De préférence, les plots métalliques sont en cuivre. Selon un procédé de fabrication donné à titre d'exemple, les plots métalliques 30, 36 sont fabriqués avant l'assemblage du substrat 10 par dépôt d'une couche métallique sur un empilement de base du substrat. Cette couche métallique est ensuite gravée suivant un motif prédéterminé pour former les plots 30 et 36, puis elle est recouverte par d'autres couches du substrat 10. Lorsque le substrat 10 est ensuite pressé par laminage pour finaliser la fabrication du capteur 6, les couches viennent en contact au niveau des interfaces 24 et 26, respectivement, et comblent le vide laissé par le métal enlevé par la gravure.

Dans l'exemple illustré, le via traversant 28 est disposé au voisinage de la bobine 12. Des plots métalliques 30 sont disposés dans l'interface 26, où est disposée la face inférieure de la bobine 12.

Par exemple, les plots métalliques ont une forme circulaire ou carrée et sont disposés autour de la section du via traversant 28 dans cette interface 26.

De préférence, des plots métalliques 32 sont disposés aux extrémités supérieure et inférieure du via traversant 28 sur les faces, respectivement, supérieure et inférieure du substrat 10.

Dans l'exemple illustré, un deuxième via traversant 34, similaire au via traversant 28, est disposé au voisinage de la deuxième bobine 14. Des plots métalliques 36 analogues aux plots métalliques 30 sont disposés dans l'interface 24.

Ces exemples ne sont pas limitatifs et d'autres vias traversants peuvent être configurés différemment. En variante, les vias traversants 28, 34 peuvent être omis.

Selon des modes de réalisation particulièrement avantageux, le capteur de courant 6 comporte au moins une couche ferromagnétique 40, 42 intégrée dans la ou chaque portion du substrat isolant 10 entourée par la ou chaque bobine, de sorte que ladite bobine entoure ladite couche ferromagnétique.

Dans l'exemple illustré, une première couche ferromagnétique 40 est intégrée dans la première portion du substrat 10 qui est entourée par la première bobine 12, entre la face supérieure du substrat 10 et l'interface 24.

Une deuxième couche ferromagnétique 42 est intégrée dans la deuxième portion de substrat 10 qui est entourée par la deuxième bobine 14, entre la face inférieure du substrat 10 et l'interface 26.

Grâce à l'adjonction d'une telle couche ferromagnétique, le gain du capteur de courant 6 est amélioré. Cela permet, in fine, d'améliorer la précision de la mesure de courant par le capteur de mesure 6 et par le système de mesure 2.

Dans un exemple non limitatif donné à titre d'illustration, les inventeurs ont constaté que, grâce aux modes de réalisation de l'invention, le gain de mesure du capteur de courant 6 peut être amélioré d'un facteur supérieur ou égal à cinq par rapport aux enroulements de Rogowski sur circuit imprimé connus, par exemple pour obtenir un gain supérieur ou égal à 80 µV par Ampère.

Cette augmentation du gain est particulièrement avantageuse lorsque le capteur 6 est utilisé comme capteur de courant dans un appareil de protection électrique au sein d'une installation de distribution d'électricité. En effet, un appareil de protection électrique doit pouvoir être déclenché rapidement dès qu'un défaut électrique est mesuré. Or, certains moyens de traitement du signal, tels que des intégrateurs passifs, introduisent une atténuation du signal qui, avec des capteurs de courant présentant un faible gain, ce qui peut dégrader le signal au point de compromettre la capacité du circuit de traitement 8 à détecter le défaut électrique. L'utilisation d'un intégrateur numérique permettrait de n'atténuer que faiblement le signal mesuré, mais aurait pour inconvénient d'introduire un temps de latence élevé au point que l'appareil de protection ne pourrait pas réagir suffisamment rapidement en cas de détection d'un défaut électrique. Au contraire, grâce au capteur 6, le circuit de traitement 8 peut inclure un simple intégrateur passif, ce qui est plus simple à fabriquer et permet d'éviter les problèmes précités.

En variante, le nombre de couches ferromagnétiques peut être différent. Il est par exemple choisi en fonction du nombre de bobines 12 ou 14. On comprend donc que, dans les variantes où la bobine 14 est omise, la couche 42 peut également être omise.

De préférence, chaque bobine 12 ou 14 n'entoure qu'une seule couche ferromagnétique.

En pratique, la première bobine 12 passe au travers de la première couche ferromagnétique 40. La deuxième bobine 14 passe au travers de la deuxième couche ferromagnétique 42. De préférence, les bobines 12 et 14 ne sont pas en contact électrique avec les couches ferromagnétiques 40 et 42.

Selon des exemples, les couches ferromagnétiques 40 et 42 sont identiques.

De préférence, les couches ferromagnétiques 40 et 42 ont des dimensions et des dispositions géométriques similaires ou identiques, par exemple alignées ou superposées l'une par rapport à l'autre selon une direction perpendiculaire au plan du substrat 10.

Dans ce qui suit, seule la couche ferromagnétique 40 est décrite en détail, mais cet enseignement est transposable à la couche ferromagnétique 42.

Selon des modes de réalisation, la couche ferromagnétique 40 comporte une sous-couche d'un alliage de fer et de nickel 44 et deux sous-couches de cuivre 46, 48 empilées de part et d'autre de la sous-couche 44.

Par exemple, l'alliage de fer et de nickel est un alliage Fe-Ni36%, aussi connu sous la marque déposée « Invar ». Cet alliage permet avantageusement d'obtenir de bonnes propriétés magnétiques, tout en ayant des propriétés mécaniques qui facilitent la construction et la tenue du substrat 10.

La couche ferromagnétique 40 peut être formée par dépôt de matière, ou être construite sous la forme d'une plaque intégrée dans le substrat 10 lors de sa fabrication.

En variante, d'autres matériaux peuvent être utilisés pour former la couche ferromagnétique 40, tels qu'un alliage métallique ferromagnétique.

Selon des modes de réalisation, la couche ferromagnétique 40 est supérieure ou égale à 150 µm, ou supérieure ou égale à 250 µm.

Dans l'exemple illustré, la couche ferromagnétique 40 est disposée entre une première sous-couche 41 du substrat 10 et une deuxième sous-couche 43 du substrat. L'interface 24 est formée entre la deuxième sous-couche 43 et une couche du coeur du substrat 10. Une disposition similaire est utilisée pour la couche ferromagnétique 42 vis-à-vis de l'interface 26.

Dans un exemple non limitatif donné à titre d'illustration, l'épaisseur totale du substrat 10, mesurée selon une direction perpendiculaire au plan du substrat 10, peut être comprise entre 0,1 cm et 1 cm.

Selon des modes de réalisation, lorsqu'un ou plusieurs via traversants 28, 34 traversent le substrat 10, la couche ferromagnétique 40 peut être séparée latéralement dudit via traversant 28, 34 par une zone tampon 50 dépourvue de matériau ferromagnétique.

On comprend que cette zone tampon 50 est disposée dans l'alignement de la couche ferromagnétique 40.

Selon des exemples, la zone tampon 50 peut être remplie d'un matériau électriquement isolant, ou être formée par un évidement dans la couche ferromagnétique 40. En d'autres termes, la couche ferromagnétique 40 n'est pas en contact électrique avec les vias traversants 28 et 34. L'évidement peut être obtenu par perçage de la couche ferromagnétique ou par gravure de la couche ferromagnétique.

Par exemple, la zone tampon 50 est dimensionnée pour que la distance entre le bord latéral du via traversant 28, 34 et le matériau ferromagnétique de la couche ferromagnétique 40 le plus proche dudit bord latéral, cette distance étant mesurée selon une direction parallèle au plan du substrat 10, soit supérieure ou égale à 25% de la largeur dudit via traversant.

Dans un exemple non limitatif donné à titre d'illustration, la largeur du via traversant 28 est égale à 650 µm. De chaque côté du via traversant 28, la zone tampon 50 a une largeur supérieure ou égale à 200 µm.

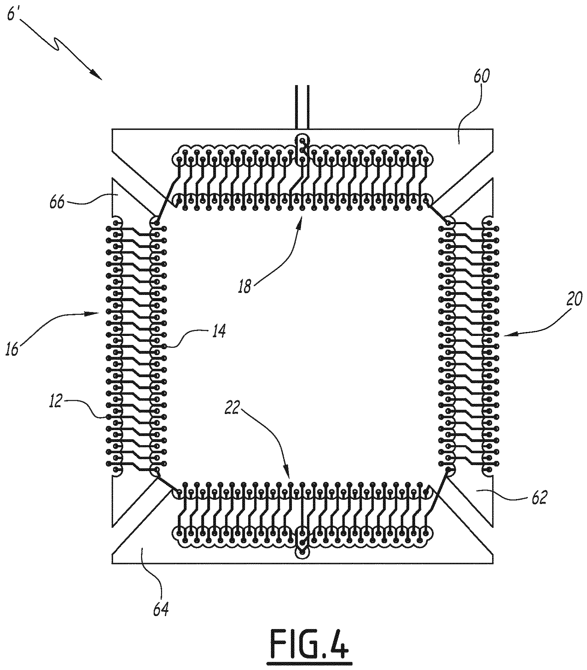

La figure 4 représente un capteur de courant 6' selon un deuxième mode de réalisation. Les éléments de capteur de courant 6' qui sont analogues au premier mode de réalisation portent les mêmes références et ne sont pas décrits en détail, dans la mesure où la description faite ci-dessus en référence aux figures 2 et 3 peut leur être transposée.

Le capteur de courant 6' est essentiellement identique ou similaire au capteur de courant 6, et comporte notamment une pluralité de portions de bobine 14, 18, 20 et 22.

Le capteur de courant 6' diffère notamment du capteur de courant 6 par le fait que chaque couche ferromagnétique 40, 42 est divisée, dans le plan de la couche ferromagnétique, en plusieurs parties de préférence isolées électriquement l'une de l'autre, chacune de ces parties étant associée à une des portions de bobine 14, 18, 20 et 22.

Dans l'exemple illustré, la plaque 40 est divisée en quatre parties 60, 62, 64 et 66 respectivement associées aux portions de bobines 18, 20, 22 et 16.

On comprend que les parties 60, 62, 64 et 66 sont électriquement isolées les unes des autres, en étant par exemple séparées, dans le plan de la couche ferromagnétique 40, par une zone dépourvue de matériau magnétique ou par un matériau électriquement isolant, par exemple à l'instar des zones tampon 50 précédemment décrites.

Par « associée à une portion de bobine », on entend ici que la portion de bobine correspondante entoure ladite partie de couche ferromagnétique et qu'elle est alignée avec ladite partie de couche ferromagnétique selon une direction perpendiculaire au plan du substrat 10.

En pratique, chaque partie de la couche ferromagnétique 40, 42 est associée à une seule des portions de bobine 16, 18, 20 et 22.

Une telle division de la couche ferromagnétique permet avantageusement d'éviter une saturation magnétique prématurée de la couche ferromagnétique lorsque le courant circulant dans le conducteur 4 atteint des valeurs élevées. Les avantages apportés par la présence de la couche ferromagnétique en termes de gain sont néanmoins préservés.

Là encore, ce mode de réalisation n'est pas limité par le nombre de portions de bobine 16, 18, 20 et 22 ou par le nombre de parties de couche ferromagnétique 40, 42.

Bien que cela ne soit pas illustré en détail, on comprend qu'il en va de même pour la couche 42, qui est elle aussi divisée de façon analogue.

De façon avantageuse, les parties 60, 62, 64 et 66 de couche magnétique peuvent être formées en déposant des couches magnétiques similaires aux couches 40 et 42 pendant la fabrication du substrat puis en découpant ces couches en perçant le substrat au moyen d'un outil de perçage. Par exemple, plusieurs trous sont percés perpendiculairement au plan du substrat dans les coins des couches pour former des entrefers qui délimitent les parties 60, 62, 64 et 66. Cette méthode permet de découper simultanément les deux couches ferromagnétiques de l'empilement de la même façon et ainsi d'obtenir des parties 60, 62, 64 et 66 de mêmes dimensions pour les deux couches ferromagnétiques. De plus, la largeur de l'entrefer peut être facilement réglée en choisissant un outil de perçage plus ou moins gros, ce qui permet de régler facilement la valeur du gain du capteur.

L'invention est définie par les revendications annexées.

## Revendications

1. Capteur de courant (6 ; 6'), comportant :
- un substrat isolant (10) pourvu d'une ouverture centrale, l'ouverture centrale (7) étant configurée pour recevoir un conducteur électrique (4) ;
- un enroulement entourant l'ouverture centrale et incluant une bobine (12, 14) enroulée autour d'une portion du substrat isolant ;
dans lequel le capteur de courant comporte au moins une couche ferromagnétique (40, 42) intégrée dans la portion du substrat isolant, la bobine (12, 14) entourant la couche ferromagnétique
**caractérisé en ce que** l'enroulement comporte en outre une bobine additionnelle (14) enroulée autour d'une autre portion du substrat décalée selon une direction perpendiculaire au plan du substrat (10), les deux bobines (12, 14) étant entrelacées et connectées électriquement en série, et dans lequel une couche ferromagnétique (42) additionnelle est intégrée dans ladite autre portion du substrat isolant, la bobine additionnelle (14) entourant la couche ferromagnétique additionnelle.

2. Capteur de courant (6 ; 6') selon la revendication 1, dans lequel la bobine (12) comporte une pluralité de portions de bobine (16, 18, 20, 22) connectées électriquement en série, les portions de bobine étant de forme rectiligne et agencées de manière à former un contour fermé en forme de quadrilatère autour de l'ouverture centrale.

3. Capteur de courant (6) selon la revendication 2, dans lequel la couche ferromagnétique (40, 42) est commune à toutes les portions de bobines.

4. Capteur de courant (6') selon la revendication 2, dans lequel la couche ferromagnétique est divisée en plusieurs parties (60, 62, 64, 66) chacune associée à une des portions de bobine (16, 18, 20, 22).

5. Capteur de courant (6 ; 6') selon l'une quelconque des revendications précédentes, dans lequel la couche ferromagnétique (40, 42) comporte une sous-couche d'un alliage de fer et de nickel (44) et deux sous-couches de cuivre (46, 48) empilées de part et d'autre de la sous-couche d'alliage de fer et de nickel.

6. Capteur de courant (6 ; 6') selon la revendication 5, dans lequel l'alliage de fer et de nickel est un alliage Fe-Ni36%.

7. Capteur de courant (6 ; 6') selon l'une quelconque des revendications précédentes, dans lequel l'épaisseur de la couche ferromagnétique (40, 42) est supérieure ou égale à 150 µm.

8. Capteur de courant (6 ; 6') selon l'une quelconque des revendications précédentes, dans lequel le substrat (10) comporte un via traversant (28, 34) perpendiculaire au plan du substrat, et dans lequel la couche ferromagnétique (40, 42) est séparée dudit via traversant (28, 34) par une zone tampon (50) dépourvue de matériau ferromagnétique.

9. Capteur de courant (6 ; 6') selon l'une quelconque des revendications précédentes, dans lequel le substrat (10) est un support de circuit imprimé comportant une ou plusieurs couches empilées d'un matériau polymère durci.

10. Système de mesure (2) **caractérisé en ce qu'**il comporte un capteur de courant (6 ; 6') selon l'une quelconque des revendications précédentes et un circuit électronique de traitement (8) configuré pour traiter le signal mesuré par le capteur de courant (6 ; 6').

## Patentansprüche

1. Stromsensor (6; 6'), umfassend:
- ein isolierendes Substrat (10), das mit einer mittleren Öffnung versehen ist, wobei die mittlere Öffnung (7) konfiguriert ist, um einen elektrischen Leiter (4) aufzunehmen;
- eine Wicklung, die die mittlere Öffnung umgibt und eine Spule (12, 14) beinhaltet, die um einen Abschnitt des isolierenden Substrats gewickelt ist;
wobei der Stromsensor mindestens eine ferromagnetische Schicht (40, 42) umfasst, die in den Abschnitt des isolierenden Substrats integriert ist, wobei die Spule (12, 14) die ferromagnetische Schicht umgibt
**dadurch gekennzeichnet, dass** die Spule ferner eine zusätzliche Spule (14) umfasst, die um einen weiteren Abschnitt des Substrats gewickelt ist, der in einer Richtung senkrecht zu der Ebene des Substrats (10) versetzt ist, wobei die zwei Spulen (12, 14) miteinander verschränkt und elektrisch in Reihe verbunden sind, und wobei eine zusätzliche ferromagnetische Schicht (42) in den weiteren Abschnitt des isolierenden Substrats integriert ist, wobei die zusätzliche Spule (14) die zusätzliche ferromagnetische Schicht umgibt.

2. Stromsensor (6; 6') nach Anspruch 1, wobei die Spule (12) eine Vielzahl von Spulenabschnitten (16, 18, 20, 22) umfasst, die elektrisch in Reihe verbunden sind, wobei die Spulenabschnitte eine geradlinige Form aufweisen und ausgebildet sind, um eine geschlossene Kontur in Form eines Vierecks um die mittlere Öffnung zu bilden.

3. Stromsensor (6) nach Anspruch 2, wobei die ferromagnetische Schicht (40, 42) allen Spulenabschnitten gemeinsam ist.

4. Stromsensor (6') nach Anspruch 2, wobei die ferromagnetische Schicht in mehrere Abschnitte (60, 62, 64, 66) unterteilt ist, die jeweils mit einem der Spulenabschnitte (16, 18, 20, 22) assoziiert sind.

5. Stromsensor (6; 6') nach einem der vorherigen Ansprüche, wobei die ferromagnetische Schicht (40, 42) eine Teilschicht aus einer Eisen- und Nickellegierung (44) und zwei Kupferunterschichten (46, 48) umfasst, die auf beiden Seiten der Teilschicht aus Eisen- und Nickellegierung gestapelt sind.

6. Stromsensor (6; 6') nach Anspruch 5, wobei die Eisen- und Nickellegierung eine Fe-Ni36 %-Legierung ist.

7. Stromsensor (6; 6') nach einem der vorherigen Ansprüche, wobei die Stärke der ferromagnetischen Schicht (40, 42) größer als oder gleich wie 150 µm ist.

8. Stromsensor (6; 6') nach einem der vorherigen Ansprüche, wobei das Substrat (10) eine Durchkontaktierung (28, 34) senkrecht zu der Substratebene aufweist und wobei die ferromagnetische Schicht (40, 42) durch eine Pufferzone (50), die frei von ferromagnetischem Material ist, von der Durchkontaktierung (28, 34) getrennt ist.

9. Stromsensor (6; 6') nach einem der vorherigen Ansprüche, wobei das Substrat (10) ein Träger für eine Leiterplatte ist, die eine oder mehrere gestapelte Schichten aus einem gehärteten Polymermaterial umfasst.

10. Messsystem (2), **dadurch gekennzeichnet, dass** es einen Stromsensor (6; 6') nach einem der vorherigen Ansprüche und eine elektronische Verarbeitungsschaltung (8) umfasst, die konfiguriert ist, um das von dem Stromsensor (6; 6') gemessene Signal zu verarbeiten.

## Claims

1. Current sensor (6; 6'), comprising:
- an insulating substrate (10) provided with a central opening, the central opening (7) being configured to receive an electrical conductor (4);
- a winding surrounding the central aperture and including a coil (12, 14) wound around a portion of the insulating substrate;
in which the current sensor comprises at least one ferromagnetic layer (40, 42) integrated in the portion of the insulating substrate, the coil (12, 14) surrounding the ferromagnetic layer
**characterised in that** the winding further comprises an additional coil (14) wound around a further portion of the substrate offset in a direction perpendicular to the plane of the substrate (10), the two coils (12, 14) being interleaved and electrically connected in series, and wherein an additional ferromagnetic layer (42) is embedded in said further portion of the insulating substrate, the additional coil (14) surrounding the additional ferromagnetic layer.

2. Current sensor (6; 6') as claimed in claim 1, wherein the coil (12) comprises a plurality of coil portions (16, 18, 20, 22) electrically connected in series, the coil portions being rectilinear in shape and arranged to form a closed quadrilateral contour around the central opening.

3. Current sensor (6) according to claim 2, in which the ferromagnetic layer (40, 42) is common to all the coil portions.

4. Current sensor (6') according to claim 2, in which the ferromagnetic layer is divided into several parts (60, 62, 64, 66) each associated with one of the coil portions (16, 18, 20, 22).

5. Current sensor (6; 6') according to any one of the preceding claims, in which the ferromagnetic layer (40, 42) comprises an under layer of an iron-nickel alloy (44) and two copper under layers (46, 48) stacked on either side of the iron-nickel alloy under layer.

6. Current sensor (6; 6') according to claim 5, wherein the iron-nickel alloy is an Fe-Ni36% alloy.

7. Current sensor (6; 6') according to any of the preceding claims, in which the thickness of the ferromagnetic layer (40, 42) is greater than or equal to 150 µm.

8. Current sensor (6; 6') according to any one of the preceding claims, in which the substrate (10) comprises a through via (28, 34) perpendicular to the plane of the substrate, and in which the ferromagnetic layer (40, 42) is separated from said through via (28, 34) by a buffer zone (50) devoid of ferromagnetic material.

9. urrent sensor (6; 6') according to any one of the preceding claims, wherein the substrate (10) is a printed circuit substrate comprising one or more stacked layers of a cured polymer material.

10. Measurement system (2), **characterised in that** it comprises a current sensor (6; 6') according to any one of the preceding claims and an electronic processing circuit (8) configured to process the signal measured by the current sensor (6; 6').
